Europäisches Patentamt

European Patent Office

Office européen des brevets

(11) Publication number:

**0 144 208**
**A1**

(12) **EUROPEAN PATENT APPLICATION**

(21) Application number: 84308238.9

(22) Date of filing: 28.11.84

(51) Int. Cl.⁴: **H 02 H 9/04**
**H 01 L 27/02**

(30) Priority: 30.11.83 JP 224303/83

(43) Date of publication of application:
12.06.85 Bulletin 85/24

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Sugihara, Takanori c/o FUJITSU LIMITED
Patent Department 1015 Kamikodanaka
Nakahara-ku Kawasaki-shi Kanagawa 211(JP)

(72) Inventor: Shimauchi, Yoshiki c/o FUJITSU LIMITED
Patent Department 1015 Kamikodanaka
Nakahara-ku Kawasaki-shi Kanagawa 211(JP)

(74) Representative: Sunderland, James Harry et al,
HASELTINE LAKE & CO Hazlitt House 28 Southampton
Buildings Chancery Lane
London WC2A 1AT(GB)

(54) A protecting circuit for a semiconductor device.

(57) A protecting circuit (5) for protecting a TTL IC (1) from static charge breakdown. The base of a transistor (6), used for bypassing static charge applied to an input line (IN) of a TTL IC(1), is biased by a voltage which includes the potential drop across a diode (7) provided between the base and the emitter of the transistor. Hence, the transistor is caused to turn on by a relatively brief flow of static charge.

FIG.2

0144208

## A PROTECTING CIRCUIT FOR A SEMICONDUCTOR DEVICE

The present invention relates to a protecting circuit for a semiconductor device.

Damage to ICs (Integrated Circuits) caused by surges of static electricity has been a matter of great concern for the manufacturers and users of ICs. For example, in an MOS (Metal Oxide Semiconductor) device, the insulating oxide layer formed between a gate and the semiconductor substrate is liable to be damaged by accidental input of static charges to the gate.

Since static charges are often generated as frictional electricity and accumulated on the body of a person manipulating ICs, some measures already exist which aim to prevent the generation and accumulation of static charges, or to prevent static charges from reaching an IC. Furthermore, in some cases a protection circuit is provided for each input terminal of an IC.

In recent years, static charge breakdown has also become a serious problem regarding TTL ICs. Most TTL ICs have an emitter-input configuration, i.e. each input terminal is connected to an emitter of a transistor, and the susceptibility of such a TTL IC to static charge breakdown is dependent upon the depth of the impurity diffusion layer constituting an emitter. Static charge breakdown in a TTL IC usually results in shorting (short mode) of a base-emitter junction, or in degradation of reverse current characteristics of the junction if halted at an early stage. Static charge breakdown is observed to be due to migration of the electrode material such as aluminium into the base-emitter junction, the migration being caused by the surge of static charges.

The TTL ICs of previous years have been quite resistant to such static charge breakdown, because in these ICs the depth of the emitter region is relatively large. However, in the most recent TTL ICs, this depth has become smaller and smaller along with the trend towards finer structure of the circuit components to meet requirements for low power consumption and high speed operation, and their resistance against static electricity has diminished. As a result, damage caused by static charge during transporting of TTL ICs or mounting of them onto printed-circuit boards, has become a serious problem. Therefore, in many kinds of modern TTL ICs, as well as in MOS ICs, protecting circuits for protection against static charge breakdown are incorporated.

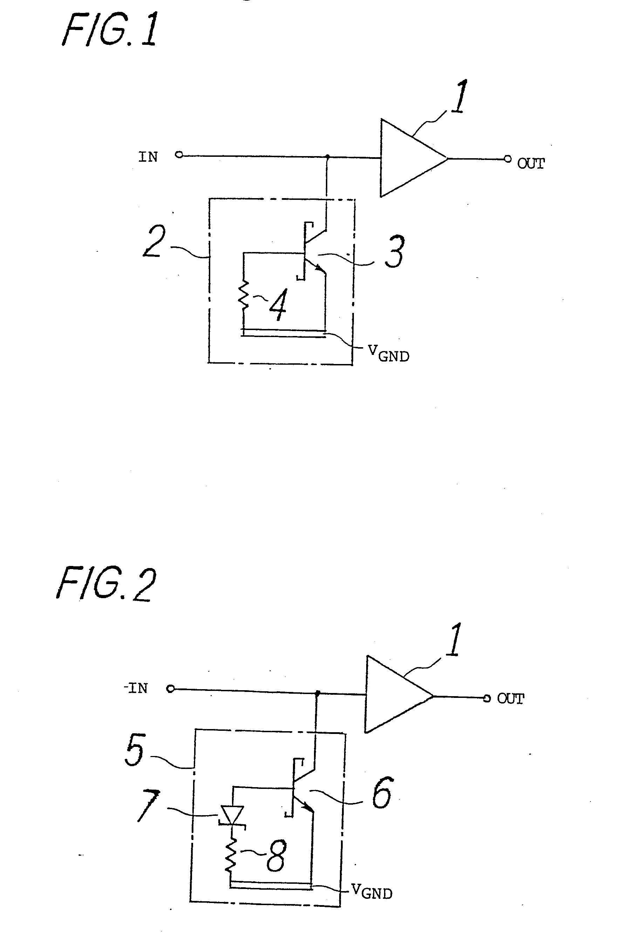

Fig.1 is a circuit diagram showing a previous protecting circuit for preventing static charge breakdown. In Fig.1, the input line IN of a semiconductor device 1, a TTL IC, for example, is connected to a protecting circuit 2. The protecting circuit 2 comprises a transistor 3 whose collector and emitter are respectively connected to the input line IN and a potential source line $V_{GND}$, a ground line for example. The base of the transistor 3 is connected to the emitter, namely to the potential source line $V_{GND}$, via a resistor 4.

When static charges appear on the input line IN creating a positive potential, the potential on the line IN rises at a rate determined by the input impedance and the floating capacitance of the line. As soon as the potential exceeds the breakdown voltage of the base-collector junction of the transistor 3, a leak current flows through the resistor 4, hence, a bias voltage corresponding to the potential drop across the resistor 4 is applied to the base of the transistor 3. If this bias voltage is larger than the ON-state voltage, i.e. the base-emitter voltage $V_{BE}$, of the transistor 3, the transistor 3 turns ON and the positive static charges on the input line IN are rapidly discharged to the line

-3-

$V_{GND}$ through the emitter. Thus, the semiconductor device 1 is protected from the voltage surge due to the static charges.

When negative static charges appear on the input line IN creating a negative potential, the charges are discharged through a diode (usually referred to as an input-clamping diode; not shown) connected between the input line IN and the potential source line $V_{GND}$ in the reverse direction with respect to current from the line IN to the source line $V_{GND}$.

Clearly, it is necessary for the transistor 3 to turn on before the potential on the input line IN reaches a voltage sufficient to cause static charge breakdown in the input circuitry of the device 1. Therefore, the bias voltage applied to the base of the transistor 3 immediately after Zener breakdown takes place in the base-collector junction, should be equal to or higher than the voltage $V_{BE}$ (base-emitter voltage in the forward direction) of the transistor 3. If not, there is a delay before the protecting circuit starts to operate, and if this delay is too great, static charge breakdown is likely to occur before the protecting circuit 2 functions. From this point of view, it is necessary that the resistance value of the resistor 4 is made properly large.

However, the larger the value of a resistor in an IC, the larger the area occupied by the impurity diffusion layer required to constitute the resistor. Thus, it is difficult to produce a resistor 4 of sufficient resistance value in a fine-structured (TTL) IC. Furthermore, it is difficult to build protecting circuits with uniform characteristics in a (TTL)IC, because of the difficulty of fabricating resistors 4 having a uniform large value throughout the IC. Accordingly, the protecting circuit as shown in Fig.1 is

not very effective, in practice , for protecting modern (TTL) ICs from static charge breakdown.

According to an embodiment of the present invention, each input line of a semiconductor device is provided with a protecting circuit comprising a transistor having an emitter connected to a reference potential source line and a collector connected to an input terminal of the semiconductor device to be protected from static charge breakdown, a resistive means connected to the reference potential source line, and a diode connected in the forward direction between the base of the transistor and the resistive means.

For maximizing the speed of operation of the protecting circuit, which depends upon the biasing of the base of the transistor relative to the emitter, the diode is preferably a Schottky-barrier diode. Further, the transistor may be a Schottky-barrier diode-clamped transistor.

The same function is attained by the converse connection of the resistive means and the diode, i.e. the resistive means may be connected to the base of the transistor, and the diode connected between the resistive means and the reference potential source.

An embodiment of the present invention can provide particularly a circuit for protecting an input circuit of a TTL (Transistor-Transistor Logic) integrated semiconductor device from static charge breakdown.

An embodiment of the present invention can provide a protecting circuit (protection circuit) effective for preventing static charge breakdown for example in a fine-structured (highly integrated) TTL IC.

An embodiment of the present invention can provide accelerated operation of a protecting circuit for example of a TTL IC, so as to limit a surge of positive voltage due to static electricity on an input line before damage

-5-                                    0144208

is caused to input circuitry of the IC.

Reference is made, by way of example, to the accompanying drawings in which:-

Fig.1 is a circuit diagram of a previous protecting circuit for preventing static charge breakdown of a semiconductor device;

Fig.2 is a circuit diagram of a protecting circuit according to an embodiment of the present invention for preventing static charge breakdown of a semiconductor device;

Fig.3 is a graph showing conceptual voltage-current (V-I) characteristics of a resistor and a diode;

Fig.4(a) is a partial plan view of an exemplary configuration of the protecting circuit shown in Fig.2 on a semiconductor substrate;

Figs.4(b) and 4(c) are cross-sectional views of the configuration shown in Fig.4(a); and

Fig.5 is a circuit diagram of another embodiment of the present invention.

Fig.2 is a circuit diagram showing a protecting circuit according to an embodiment of the present invention, for preventing static charge breakdown.  In Fig.2, 1 is a semiconductor device, for example a TTL IC. A protecting circuit 5 comprises a transistor 6 whose collector and emitter are respectively connected to an input line IN and to a potential source line or terminal $V_{GND}$, for example ground.  The base of the transistor 6 is connected to the emitter, namely, to the potential source line $V_{GND}$, via a diode 7 and a resistor 8 connected in series.  The diode 7, which is preferably a Schottky-barrier diode, is connected in a forward direction with respect to current from the base to $V_{GND}$. The transistor 6 may be a bipolar npn transistor or a Schottky-barrier diode-clamped transistor.

As explained with reference to Fig.1, when static charges such as to cause a positive potential are applied to the input line IN in Fig.2, the potential on the input line IN rises at a rate determined by the impedance and floating capacitance of the input line IN. As soon as the potential on the input line IN exceeds the breakdown voltage of the base-collector junction of the transistor 6, a leak current flows from the base to the potential source line $V_{GND}$ via the diode 7 and resistor 8. At this moment, the base of the transistor 6 has applied to it a bias voltage corresponding to the potential drop across the combined impedance of the serially connected diode 7 and resistor 8. If this bias voltage is larger than the base-emitter voltage $V_{BE}$, the transistor 6 immediately turns ON, and the positive static charges on the input line IN are rapidly discharged from the collector of the transistor 6 to the potential source line $V_{GND}$ through the emitter.

As in the circuit of Fig.1, when negative static charges are applied to the input line IN causing a negative potential, the charges are discharged through an input-clamping diode (not shown) connected between the input line IN and the potential source line $V_{GND}$ in the reverse direction with respect to current from the line IN to the source line $V_{GND}$.

If the semiconductor device 1 in the circuit shown in Fig.2 is a TTL IC, the absolute maximum rating of input signal voltage is +7.0 volts, in general. Therefore, the breakdown voltage of the base-collector junction of the transistor 6 in the protecting circuit 5 must be higher than the absolute maximum rating of +7.0 volts.

Representative Zener breakdown voltages of a transistor include $BV_{CEO}$ and $BV_{CBO}$. $BV_{CEO}$ represents the collector-emitter breakdown voltage in a case in which the base is open circuited, while $BV_{CBO}$ represents the collector-base breakdown voltage in a case in which the emitter of the transistor is open circuited. $BV_{CEO}$ is lower than $BV_{CBO}$. $BV_{CEO}$ corresponds to the situation in which the combined impedance of the diode 7 and resistor 8 (Fig.2) is assumed to be infinity, and $BV_{CBO}$ corresponds to the situation in which the combined impedance of the diode 7 and resistor 8 is assumed to be zero.

In the circuit shown in Fig.2, the combination of the serially connected diode 7 and resistor 8 has a definite impedance. The breakdown voltage of the base-collector junction can be represented as $BV_{CER}$ in the situation in which a resistance value R is effective between the base and emitter. $BV_{CER}$ has a value intermediate between $BV_{CEO}$ and $BV_{CBO}$, the precise value depending on the resistance value R.

Therefore ,the value of the resistor 8 in the circuit of Fig.2 can be selected so that the input voltage on the input line IN sufficient to initiate operation of the protecting circuit shown in Fig.2, is set at a level somewhat higher than the above mentioned absolute maximum rating of +7.0 volts for the TTL IC 1. Accordingly, it can be ensured that the protecting circuit does not operate and the operation of the TTL IC 1 is never affected, as long as the level of input signals applied to the input line IN is kept within the rating.

In the protecting circuit embodying the present invention shown in Fig.2, the bias voltage applied to the base of the transistor 6 immediately after the breakdown of the base-collector junction can be made higher than that in the previous protecting circuit shown in Fig.1, and the delay which may occur in operation of the previous protecting circuit, as mentioned before, can be eliminated. This is because the nonlinear (voltage-current) characteristic of the diode 7 is exploited for providing part of the base bias voltage of the transistor 6.

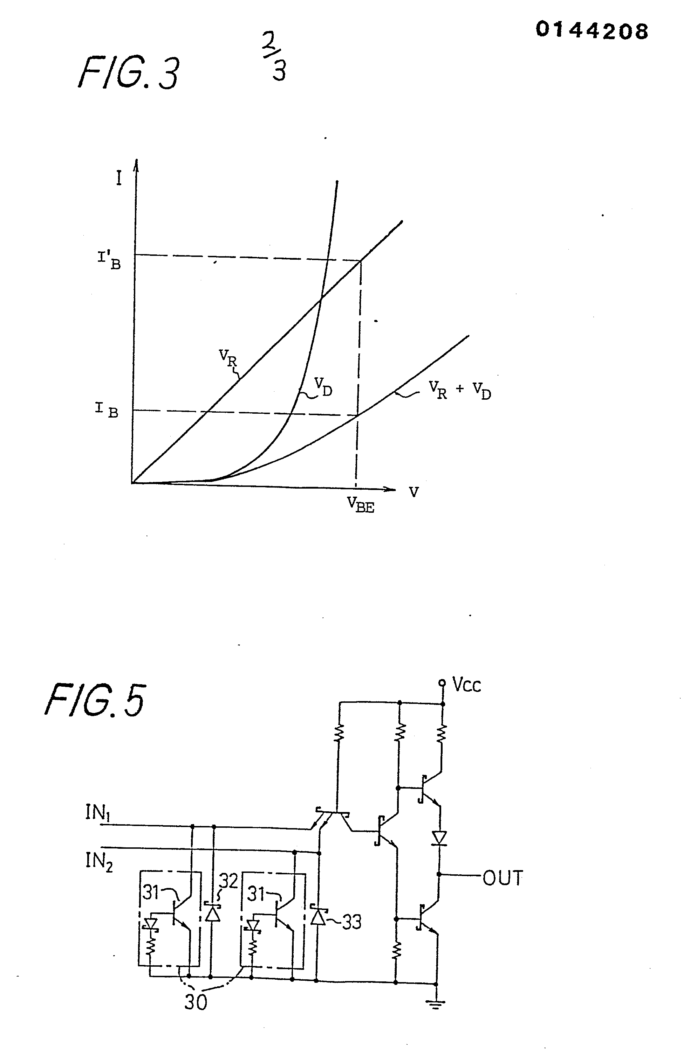

Fig.3 is a graph showing conceptual voltage-current (V-I) characteristics of a resistor R and diode D, which reveals that the diode D has a high impedance in the low current region.

Referring to Figs. 2 and 3, if a current I flows out of the base immediately after Zener breakdown of the base-collector junction of the transistor 6, a potential drop $V_D$ arises across the diode 7 and a potential drop $V_R$ arises across the resistor 8. Hence, a bias voltage of $V_D + V_R$ is applied to the base of the transistor 6. As shown in Fig.3, a bias voltage $V_{BE}$ required to turn on the transistor 6 is attained at a current $I_B$.

On the other hand, in the circuit shown in Fig.1, the corresponding bias voltage is only $V_R$, and if the bias voltage required to turn on the transistor 3 is again $V_{BE}$, operation of the protecting circuit of Fig.1 is delayed until the current has increased up to $I'_B$ along with the potential rise on the input line IN due to static charges.

In Fig.2, the protecting circuit 5 has a configuration wherein the resistor 8 is connected between the diode 7 and reference potential line $V_{GND}$. Of course, the same function of the protecting circuit 5 can be attained in the configuration wherein the diode 7 is connected between the resistor 8 and reference potential line $V_{GND}$.

Thus, in a protecting circuit embodying the present invention, discharge of static charges can be initiated by a lower current, and hence, at an earlier time, than in the previous protecting circuit shown in Fig.1. Furthermore, a protecting circuit embodying the

-9-

present invention does not require so large a value for the resistor 8 as the value required for the resistor 4 in the protecting circuit of Fig.1. The resistor 8 is needed for maintaining the diode 7 in an ON state, and cannot be eliminated entirely, however, it is relatively easily fabricated on a semiconductor substrate together with other IC components, compared with the resistor 4 in the protecting circuit of Fig.1. In a protecting circuit embodying the present invention, the transistor 6 and the diode 7 are preferably a Schottky-barrier diode-clamped transistor and a Schottky-barrier diode, respectively,as indicated in Fig.2.

In a protecting circuit embodying the invention, operation is initiated by a relatively low base current of a transistor, which allows static charges to be discharged quickly. Therefore ,the use of a Schottky-barrier diode-clamped transistor and a Schottky-barrier diode gives a significant improvement in operational speed of the protecting circuit. In the previous protecting circuit, initiation of operation is delayed until a relatively high base current has developed, and so there is no significant improvement in operational speed by the use of a Schottky-barrier diode-clamped transistor and a Schottky-barrier diode.

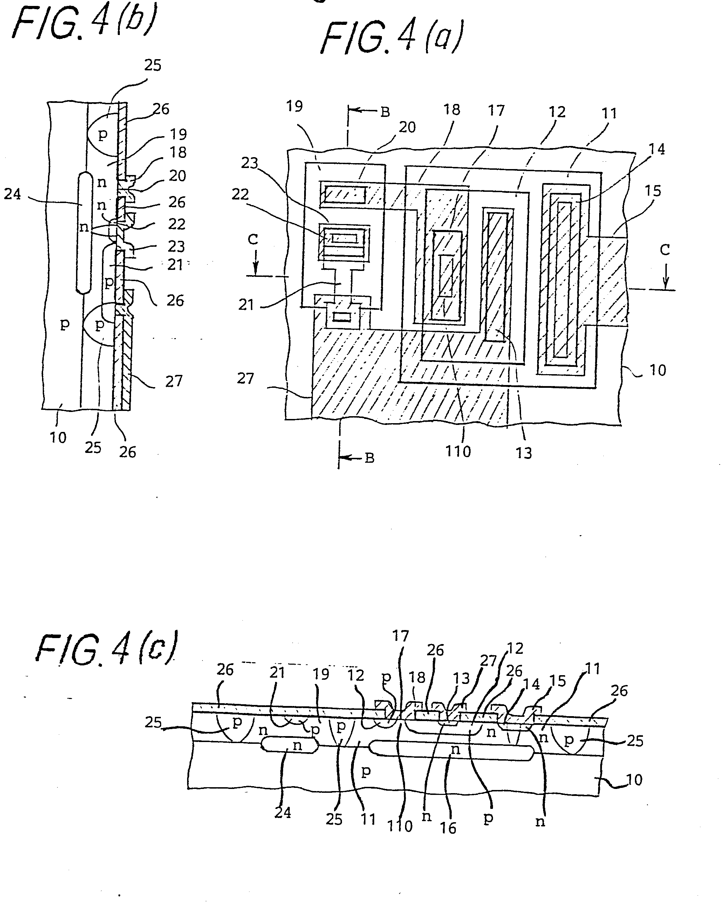

Fig.4(a) is a partial plan view of an example of an IC structure embodying the protecting circuit of Fig.2 on a semiconductor substrate, and Figs.4(b) and 4(c) are cross-sectional views of the structure, showing respective cross-sections along the lines B-B and C-C in Fig.4(a).

Referring to Figs.4(a) to 4(c), the transistor 6 in Fig.2 is implemented using an n-type epitaxial layer 11 formed on a p-type semiconductor substrate 10. The n-type epitaxial layer 11 constitutes the collector of the transistor 6. A p-type diffusion region 12 formed in the n-type epitaxial layer 11 constitutes the base. An n-type diffusion region 13, formed in the p-type diffusion region 12, constitutes the emitter. The n-type epitaxial layer 11 is connected to the input line IN of the semiconductor device 1 (not shown) of Fig.2 through an $n^+$ diffusion region 14 and a conductor layer 15. In Fig.4(c), reference numeral 16 denotes an n-type buried layer.

Adjacent to the p-type diffusion region 12, at a window 17 formed in an insulating layer 26, there is a portion 110 in which the p-type diffusion region (12) is not formed and the n-type epitaxial layer 11 is exposed, as shown in Fig.4(c). Therefore, by contacting the n-type epitaxial layer 11 at the portion 110, a conductor layer 18 forms a Schottky-barrier diode. The conductor layer 18 also contacts with the p-type diffusion region 12 exposed in the window 17 and thus constitutes the transistor base electrode. Thus, the transistor 6 is formed with a Schottky-barrier diiode connected between the base (p-type diffusion layer 12) and the collector (n-type epitaxial layer 11). In this way, the transistor 6 may be fabricated as a Schottky-barrier diode-clamped transistor.

The Schottky-barrier diode 7 connected to the base of the transistor 6 in the embodiment of Fig.2, is formed at the junction of the conductor layer 18 and another n-type epitaxial layer 19 formed on the p-type semiconductor substrate 10. Referring to Figs.4(a) and 4(b), the n-type epitaxial layer 19 is exposed at a window 20 formed in the insulating layer 26 and contacts with the conductor layer 18 extending from the window 17.

The resistor 8 in Fig.2 is fabricated from a p-type diffusion region 21 having a narrow rectangular-shaped conduction channel. The p-type diffusion region 21 is connected to the n-type epitaxial layer 19 through a conductor layer 23 and an n-type diffusion region 22. The epitaxial layer 19 is electrically separated from the n-type epitaxial layer 11 by a p-type isolation region 25. In Figs. 4(b) and 4(c), reference numeral 24 denotes an n-type buried layer. In Figs. 4(a) to 5(c), reference numeral 27 denotes a conductor layer which is connected to one end of the p-type diffusion region 21 (constituting the resistor 8 in Fig.2) and to the n-type diffusion region 13 (constituting the emitter of the transistor 6 in Fig.2), and in operation is connected to a negative potential, the ground level $V_{GND}$, for example.

Fig.5 is a circuit diagram presenting another embodiment of the present invention. In the circuit shown in Fig.5, one protecting circuit 30 having a configuration as shown in Fig.2, is provided for each of the input terminals $IN_1$ and $IN_2$ of an ordinary TTL 2-input NAND circuit. In each of the protecting circuits 30, the transistor 31 is shown as an ordinary bipolar transistor, however, it may be replaced by a Schottky-barrier diode-clamped transistor.

As explained above with respect to Fig.2, in the circuit shown in Fig.5, positive-voltage static charges applied to either or both of the input terminals $IN_1$ and $IN_2$ are rapidly discharged through the respective protecting circuit 30, while negative-voltage static charges applied to either or both of the input terminals $IN_1$ and $IN_2$ are rapidly discharged through the respective clamping diodes 32 and 33. Thus, the TTL 2-input NAND circuit can be protected from static charge breakdown due to positive or negative static charges.

**0144208**

CLAIMS

1.    A protecting circuit for a semiconductor device, comprising:

a transistor, an emitter of which is connected to a reference potential source terminal, and a collector of which is connected to an input terminal of the semiconductor device to be protected;

a circuit comprising a resistive means and a diode connected in series, said circuit being connected between a base of said transistor and the reference potential source terminal.

2.    A protecting circuit as claimed in claim 1, wherein said transistor is an npn type transistor.

3.    A protecting circuit as claimed in claim 1, or 2, wherein said transistor is a Schottky-barrier diode-clamped transistor.

4.    A protecting circuit as claimed in claim 1,2 or 3, wherein said diode is a Schottky-barrier diode.

5.    A protecting circuit as claimed in any preceding claim, wherein each of said transistor, resistive means and diode is formed on a semiconductor substrate.

6.    A protecting circuit as claimed in claim 5, wherein each of said transistor, resistive means and diode is formed on a semiconductor substrate together with the circuitry of a semiconductor device .to be protected.

7.    A protecting circuit as claimed in claim 5 or 6, wherein said resistive means is formed from an impurity diffusion layer.

8.    A protecting circuit as claimed in any preceding claim, further comprising a clamping diode connected between the reference potential source terminal and the input terminal.

*FIG.1*

*FIG.2*

## FIG.3

## FIG.5

FIG. 4 (b)

FIG. 4 (a)

FIG. 4 (c)

0144208

European Patent Office

EUROPEAN SEARCH REPORT

. Application number

EP 84 30 8238

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENTS ABSTRACTS OF JAPAN, vol. 7, no. 272 (E-214)[1417], 3rd December 1983; & JP - A - 58 153 361 (NIPPON DENKI K.K.) 12-09-1983 | 1-8 | H 02 H 9/04 H 01 L 27/02 |
| A | EP-A-0 042 581 (NIPPON ELECTRIC) * Whole document * | 1 | |
| A | FR-A-2 342 557 (PHILIPS) * Whole document * | 1 | |

TECHNICAL FIELDS SEARCHED (Int. Cl.4)

H 01 L
H 02 H
H 03 K

The present search report has been drawn up for all claims

| Place of search | Date of completion of the search | Examiner |
|---|---|---|
| THE HAGUE | 06-03-1985 | KOLBE W.H. |